# EUROPEAN PATENT SPECIFICATION

(11) **EP 0 704 547 B1**
(45) Date of publication and mention of the grant of the patent: **03.04.2002**
(21) Application number: 95830275.4
(22) Date of filing: 30.06.1995
(51) Int. Cl.: C23C 14/00, B65D 65/40

(54) **Deposition process for transparent barrier layer**
Verfahren zum Herstellen durchsichtiger Sperrschichten
Procédé de dépôt d'une couche barrière transparente

(30) Priority: 29.09.1994 IT RM940626
(43) Date of publication of application: 03.04.1996
(73) Proprietor: CE.TE.V. CENTRO TECNOLOGIE DEL VUOTO, I-61067 Carsoli (AQ) (IT)
(72) Inventor: Misiano, Carlo, I-00161 Roma Italia (IT); Simonetti, Enrico, I-00146 Roma (IT); Staffetti, Francesco, I-67049 Tornimparte (AQ) (IT)
(74) Representative: Gustorf, Gerhard, Dipl.-Ing.

(56) References cited:
- EP-A- 0 082 001
- EP-A- 0 437 946
- EP-A- 0 642 989
- WO-A-82/02687
- DE-A- 4 308 632
- US-A- 4 197 337
- PATENT ABSTRACTS OF JAPAN vol. 009 no. 222 (C-302) ,9 September 1985 & JP-A-60 082660 (KONISHIROKU SHASHIN KOGYO KK) 10 May 1985,

## Description

The invention relates to a process for deposition of barrier layers to vapour, gases, especially to water vapour, oxygen, etc. The barrier layers deposited by the present process, obtained by vaporisation of metale, and then partially oxidised, are obtained. In particular, by reactive deposition of aluminium in oxidising envlronment. The aim of the presented invention is to add a significant optimisation of the barrier properties, above all referring to the water vapour and oxygen, as belore said.

The results have been essentially obtained for the many experiments effected in the scientific field by the owner of the present patent application, owner even of many other patents belonging with the same field, as will be said in the following.

Owning to said experiments, it came out that the obtained effect, base of the invention, is "probably" connected to a dependence of the microstructure of the film deposited, by the presence of metallic atoms not oxidised.

The term "probably" has been used because this is an aspect which will be clarified during future experiments.

It is clear that the result is the most important aspect of this matter, in fact, as already written, through this invention, the transparent barrier layers obtained is really better in respect of the solutions the inventors know.

In the flexible and plastic packaging sector, till now there is the problem to realise transparent barrier layers to water wapour, oxygen, and so on, at a "low price". This last aspect, "low price", is quite important with this kind of the reallsations. In fact, solution until now proposed, and even realised, were essentially based on oxides deposition, by PVD and CVD techniques. They result to be more expenses, above all for the "big market" of the flexible packaging.

Recently many tentatives to reduce the cost of these coatings have been made by means of a simplification of processes and by using of raw materials very cheap. But results have not been significant. One solution very interesting was the reactive deposition of metals in oxidising environment, sometimes plasma assisted or ion assisted under vacuum.

The same owner and inventors, as said before, patented a deposition method able to maximise the plastic film speed reducing the cost of the process. See for this the patent application EP-A-629715 (corresponding to italian patent IT-A-1261918.

Moreover, EP-A-437 946 describes a method of depositing a mixed aluminium/ aluminium oxide barrier layer on a plastic web. EP-A-82 001 describes an apparatus and a method of metallising a length of material, in particular in the presence of oxygen; at description page 10 of this document mention is made to the possibility of forming more than one coatings.

All experiments effected by the inventors, demonstrated that the complete oxidation of the metal (especially aluminium), risulted in layers with poor or no barrier properties to water vapour, oxygen, etc. On the contrary, depositing a film oxidised not completely, that is just a little optically absorbing but without chromatic effects, a notable enhancement is obtained relatively to barrier properties. The aim of the invention lies in the fact that it utilises all traditional techniques of reactive deposition of metals, even plasma and/or ions assisted, properly controlling the oxidation level of the deposited film. The control of the oxidation level can be done in many ways: automatically, by a timer, manually, etc. for Instance, measuring the optical transparency of the layer.

At first, the invention can be considered with a low inventive, but this doubt disappears considering that this solution is able to solve the problem of obtaining barrier properties to the principal ambient factors at "low cost".

The above and other objects, features and advantages, of the present invention, will become more readily apparent from the description below keeping in mind that this version of the invention is the one actually preferred by the inventors. The invention concerns a method according to claim 1 and is particularly adapted for multipass plants (see patent application already mentionned above). In these kinds of plants, the metallic material, vaporised by an electrically heated crucible, is deposited in many successive steps with discreet increments in film thickness, on the plastic substrate, and then partially oxidised, passing through a zone with a higher pressure, in respect of the deposition zone, in which an oxidising atmosphere is inserted, also igniting a plasma.

The fundamental parameters controlled in such a configuration are:
- thickness of the single layer deposited per passage;
- pressure and composition of the residual atmosphere, in the deposition zone and in the oxidation zone;
- power and voltage characteristics which generate the discharge that ignites the plasma.
- plastic film speed;
- eventual plasma pre-treatment of the plastic film;
- plastic film temperature.

This process can be adopted, with simple modification, in traditional plants for films deposition, particularly in those known with the expression "roll-to-roll, often used in the aluminium depositions.

## Claims

1. Method for depositing transparent barrier layers to water vapour, oxygen, flavouring or the like on a web substrate of plastic film, subjecting said web substrate to a reactive evaporation process of metal, **characterised in that** the deposition of evaporated material is obtained in a series of steps with discrete increments in layer thickness of vaporized metal such as aluminium, wherein after each step the substrate with its layer passes trough a zone in which the metallic layer is partially oxidized such that the final layer is a mixture of different oxides of said vaporized metal.

2. Method according to claim 1, wherein the metal is vaporized under vacuum.

3. Method according to claim 1 or 2, wherein the partial oxidation is effected in a zone of higher pressure.

4. Method according to any of the preceding claims, wherein the partial oxidation is plasma or ion assisted under vacuum.

5. Method according to any of the preceding claims, wherein the partial oxidation is controlled by measuring the optical trasmittance of the deposited layer.

## Patentansprüche

1. Verfahren zum Aufbringen durchsichtiger Sperrschichten gegen Wasserdampf, Sauerstoff, Geschmacksstoffe oder dergleichen auf bandförmiges Substrat aus Kunststoff-Filmmaterial, wobei das Substrat einem reaktiven Verdampfungsprozess von Metall unterworfen wird, **dadurch gekennzeichnet, daß** die Ablagerung des verdampften Materials in einer Reihe von Schritten unter definierter Zunahme der Schichtdicke des verdampften Materials wie z.B. Aluminium durchgeführt wird und nach jedem Schritt das Substrat mit seiner Beschichtung eine Zone durchläuft, in der die metallische Schicht partiell oxydiert wird, so daß die endgültige Beschichtung aus einer Mischung der verschiedenen Oxide des verdampften Metalls besteht.

2. Verfahren nach Anspruch 1, **dadurch gekennzeichnet, daß** das Metall unter Vakuum verdampft wird.

3. Verfahren nach Anspruch 1 oder 2, **dadurch gekennzeichnet, daß** die partielle Oxydation in einer Zone höheren Druckes durchgeführt wird.

4. Verfahren nach einem der vohergehenden Ansprüche, **dadurch gekennzeichnet, daß** die partielle Oxydation unter Anwesenheit von Plasma oder Ionen im Vakuum durchgeführt wird.

5. Verfahren nach einem der vorhergehenden Ansprüche, **dadurch gekennzeichnet, daß** die partielle Oxydation durch Messung der optischen Durchlässigkeit der aufgebrachten Schicht gesteuert wird.

## Revendications

1. Procédé de dépôt d'une couche transparente de barrage à la vapeur d'eau, l'oxygène, les aromates ou similaires sur un substrat de film plastique en ruban, ce substrat étant soumis à un procédé réactif d'évaporation de métal, **caractérisé par le fait que** le dépôt de la matière évaporée est effectué en plusieurs étapes dans lesquelles l'épaisseur de la couche de la matière évaporée, comme par example l'aluminium, est à chaque fois augmentée de façon définie, et entre lesquelles le substrat muni de sa couche passe dans une zone où la couche métallique est partiellement oxydée de sorte que le revêtement définitif est composé d'un mélange des différents oxydes du métal évaporé.

2. Procédé selon la revendication 1, **caractérisé par le fait que** le métal est évaporé sous vide.

3. Procédé selon la revendication 1 ou 2, **caractérisé par le fait que** l'oxydation partielle est effectuée dans une zone de pression moins faible.

4. Procédé selon une quelconque des revendications précédentes, **caractérisé par le fait que** l'oxydation partielle est effectuée sous vide en présence d'ions ou de plasma.

5. Procédé selon une quelconque des revendications précédentes, **caractérisé par le fait que** l'oxydation partielle est commandée par la mesure de la transparence de la couche déposée.
